# EUROPÄISCHE PATENTANMELDUNG

(11) **EP 3 758 461 A1**
(43) Veröffentlichungstag der Anmeldung: **30.12.2020**
(21) Anmeldenummer: 20181150.2
(22) Anmeldetag: 19.06.2020
(51) Int. Cl.: H05K 7/18

(54) **ELEKTRONIKSCHRANK UND ABDECKUNGSSYSTEM FÜR EINEN ELEKTRONIKSCHRANK**

(30) Priorität: 28.06.2019 DE 202019103586 U
(71) Anmelder: Schroff SAS, 67660 Betschdorf (FR)
(72) Erfinder: WOLLJUNG, Olivier, 67110 Niederbronn-les-Bains (FR); THOMAS, Daniel, 67160 Seebach (FR)
(74) Vertreter: Grünecker Patent- und Rechtsanwälte PartG mbB

(57) **Zusammenfassung**

Die vorliegende Erfindung bezieht sich auf einen Elektronikschrank (100) mit einem Innenraum (112) zur Aufnahme von Elektronikkomponenten und auf ein Abdeckungssystem für einen Elektronikschrank. Der Elektronikschrank (100) umfasst mindestens eine Seitenwand (104), eine Rückwand (102), eine Schranktür (108) und eine linear verschiebliche Abdeckungseinheit (116), die aus einer Lagerposition in Richtung der Schranktür (108) ausziehbar ist. Weiterhin umfasst der Elektronikschrank eine zweite Abdeckungseinheit (118), die so angeordnet ist, dass sie mit der verschieblichen Abdeckungseinheit (116) in einem vollständig ausgezogenen Zustand eine geschlossene Schrankabdeckung bildet, deren Oberseite eine geschlossene Dachfläche (140) bildet, und ein Schiebehalterungssystem (120), das die verschiebliche Abdeckungseinheit (116) in ausgezogenem Zustand stützt.

## Beschreibung

Die vorliegende Erfindung bezieht sich auf einen Elektronikschrank mit einem Innenraum zur Aufnahme von Elektronikkomponenten und ein Abdeckungssystem für einen Elektronikschrank.

Elektronikschränke werden im Freien verwendet, um empfindliche Elektronikkomponenten vor Umwelteinflüssen, wie Staub, Feuchtigkeit oder starken Winden, zu schützen. Auf Grund ihrer exponierten Lage müssen solche Elektronikschränke dabei robust und widerstandsfähig gebaut sein, um die Elektonikkomponenten dauerhaft schützen zu können. Insbesondere können Elektronikschränke an Bahnstrecken eingesetzt werden, um Elektronikkomponenten, die Teil von automatischen Bahnanwendungen, wie beispielsweise automatischen Zugbeeinflussungssystemen und Zug- oder Plattformüberwachung sind, zu schützen.

Da die Elektronikschränke für solche Anwendungen in einem Abstand von 1 - 3 m von einem Gleis entfernt aufgestellt sein müssen, um einen reibungslosen und zuverlässigen Betrieb der automatischen Bahnanwendungen zu gewährleisten, müssen die Elektronikschränke eine hohe Stabilität haben, um starke Stöße und Vibrationen aushalten zu können, die von vorbeifahrenden Zügen verursacht werden. Weiterhin müssen die Elektronikschränke starke Winde mit Windstärken von bis zu 180 km/h, die von Stürmen oder vorbeifahrenden Zügen verursacht werden, ohne Beschädigungen aushalten können. Zudem sollen die Elektronikschränke erdbebensicher bis zur Bellcore Zone 4 sein und müssen auf Grund ihrer exponierten Lage ausreichenden Schutz vor Vandalismus bieten.

Um Wartungsarbeiten oder Modifikationen an den Elektronikkomponenten durchführen zu können, umfassen Elektronikschränke für gewöhnlich eine verschließbare Tür, die bei Bedarf geöffnet werden kann. Allerdings werden durch Öffnen der Tür auch die Elektronikkomponenten freigelegt. Insbesondere bei Niederschlägen, wie Regen oder Schnee kann Wasser durch die geöffnete Tür in einen Innenraum des Elektronikschrankes eindringen und dort empfindliche Elektronikkomponenten zu zerstören. Deshalb ist es notwendig zu gewährleisten, dass die Elektronikkomponenten auch bei geöffneter Tür vor Niederschlagswasser geschützt sind.

Beispielsweise ist es bekannt, für Wartungsarbeiten ein Zelt über dem zu wartenden Elektronikschrank aufzustellen, das die Elektronikkomponenten im Innenraum des Elektronikschranks und einen Wartungsarbeiter, der die Wartungsarbeiten durchführt, vor Niederschlägen und aufgewirbeltem Staub schützt. Allerdings können Zelte an Bahnstrecken nicht genutzt werden, da die Zeltplanen von den starken Windstößen, die von vorbeifahrenden Zügen erzeugt werden, fortgerissen werden und sich in den Oberleitungen verfangen können. Außerdem sind Zelte aufwendig aufzubauen und müssen für jeden Wartungsfall mittransportiert werden. Weiterhin können Zeltplanen leicht reißen und müssen jedes Mal nach Gebrauch getrocknet werden, bevor sie gelagert werden können. Zudem können Zelte leicht vergessen werden und sind teuer.

Als Alternative ist aus der US 6,052,951 A ein Gehäuse für einen Elektronikschrank mit einem ausziehbaren Wetterschutz bekannt, der mehrere Abdecksegmente umfasst, die rotierbar vor einer Zugangsseite des Gehäuses ausgezogen werden können. Dabei werden die einzelnen Abdecksegmente in einem ausgezogenen Zustand mit Hilfe von Haken aneinander befestigt. Allerdings ist ein solcher Wetterschutz materialintensiv in der Herstellung und schwierig aufzubauen, da zur Befestigung jedes einzelne der Abdecksegmente jeweils mit den benachbarten Abdecksegmenten verhakt werden muss. Weiterhin wird ein Wartungsarbeiter durch den Wetterschutz vollständig eingeschlossen, so dass er für die Wartungsarbeiten eine zusätzliche Lichtquelle benötigt und den Wetterschutz jedes Mal ab- und wieder aufbauen muss, wenn er den Wetterschutz kurz verlassen will.

Es besteht ein Bedarf an einem Elektronikschrank und einer Abdeckungsvorrichtung für einen Elektronikschrank, welche die Nachteile der bekannten Lösungen überwinden, wobei der Elektronikschrank und die Abdeckvorrichtung leicht bedienbar und einfach und kostengünstig herstellbar sein sollen. Weiterhin soll der Elektronikschrank Wartungsarbeiter und Elektronikkomponenten im Innenraum des Elektronikschrankes im Wartungsfalle bei jedem Wetter vor Feuchtigkeit und Staub schützen und dabei stabil gegenüber Vibrationen und starken Winden sein.

Diese Aufgabe wird durch den Gegenstand der unabhängigen Ansprüche gelöst. Vorteilhafte Ausführungsformen der vorliegenden Erfindung sind Gegenstand der abhängigen Ansprüche.

Ein erfindungsgemäßer Elektronikschrank mit einem Innenraum zur Aufnahme von Elektronikkomponenten umfasst mindestens eine Seitenwand, eine Rückwand und eine Schranktür, sowie eine linear verschiebliche Abdeckungseinheit, die aus einer Lagerposition in Richtung der Schranktür ausziehbar ist. Weiterhin umfasst der erfindungsgemäße Elektronikschrank eine zweite Abdeckungseinheit, die so angeordnet ist, dass sie mit der verschieblichen Abdeckungseinheit in einem vollständig ausgezogenen Zustand eine geschlossene Schrankabdeckung bildet, deren Oberseite eine geschlossene Dachfläche bildet, und ein Schiebehalterungssystem, das die verschiebliche Abdeckungseinheit in ausgezogenem Zustand stützt.

Auf diese Weise kann die Dachfläche des Elektronikschranks durch lineares Herausziehen der verschieblichen Abdeckungseinheit vergrößert werden, um so ein Vordach vor der Tür des Elektronikschrankes zu bilden, das zum einen den Innenraum des Elektronikschrankes vor einfallendem Niederschlag schützt, zum anderen aber auch einem Wartungsarbeiter einen Regenschutz bietet, so dass er selber trocken bleibt und auch benötigte Werkzeuge im Trockenen abstellen kann. Weiterhin ist der das Vordach jederzeit als Regenschutz verfügbar und kann nach Benutzung auf einfache Weise und ohne vorheriges Trocknen verstaut werden. Weiterhin ist ein solches Dach stabil und beständig gegenüber Windstärken von bis zu 180km/h, insbesondere auch in vollständig ausgefahrenem Zustand der Dachfläche. Die Dachfläche kann insbesondere auch bei trockenem Wetter vergrößert werden, um einen Schutz vor Staub und starker Sonneneinstrahlung bereitzustellen, so um beispielsweise bei Bildschirmarbeiten einen Blendschutz zu bieten.

Vorteilhafterweise kann die geschlossene Dachfläche in Richtung der Rückwand geneigt sein, so dass Niederschlagswasser im vollständig ausgezogenen Zustand von der Dachfläche abfließen kann und dabei von der Vorderseite des Elektronikschranks weggeleitet wird. Ebenfalls wird so vermieden, dass sich Niederschlagswasser auf der Dachfläche sammeln kann.

Weiterhin kann die verschiebliche Abdeckungseinheit in der Lagerposition teleskopisch über der zweiten Abdeckungseinheit gelagert sein, so dass der Elektronikschrank in platzsparender und kompakter Form hergestellt werden kann. Weiterhin ist die verschiebliche Abdeckungseinheit auf diese Weise einfach mit einer linearen Bewegung ausziehbar.

Gemäß einer vorteilhaften Weiterbildung der vorliegenden Erfindung umfasst das Schiebehalterungssystem eine Arretier-Vorrichtung, mit deren Hilfe die Position der verschieblichen Abdeckungseinheit fixiert werden kann. Vorteilhafterweise ist dabei die Arretier-Vorrichtung nur zugänglich, wenn die Schranktür des Elektronikschrankes geöffnet ist. Auf diese Weise kann die verschiebliche Abdeckungseinheit herausgezogen werden, um die Dachfläche bis hin zu einer maximal möglichen Fläche zu vergrößern und kann anschließend fixiert werden, um die gewünschte Dachfläche beizubehalten. Weiterhin kann die Arretierung nur gelöst werden, wenn die Schranktür des Elektronikschranks geöffnet ist, so dass die verschiebliche Abdeckungseinheit vor Vandalismus geschützt gelagert ist.

Gemäß einer weiteren vorteilhaften Weiterbildung der vorliegenden Erfindung umfasst die verschiebliche Abdeckungseinheit mindestens zwei trapezförmige erste Seitenflächen, eine rechteckförmige erste Stirnfläche und eine rechteckförmige erste Abdeckfläche. Vorteilhafterweise sind dabei die zwei trapezförmigen ersten Seitenflächen jeweils durch ein rechtwinkliges Trapez ausgeformt, das an einem der beiden Schenkel jeweils zwei rechte Winkel umfasst. Somit ist die verschiebliche Abdeckungseinheit auf einfache Weise durch Metallbleche herstellbar, die bündig miteinander verschweißt sind. Alternativ kann die verschiebliche Abdeckungseinheit selbstverständlich auch aus Kunststoff hergestellt sein.

Um eine hohe Kompaktheit des Elektronikschrankes zu gewährleisten und um eine Angriffsfläche für Vandalismus zu reduzieren, schließen die zwei ersten trapezförmigen Seitenflächen vorzugsweise in der Lagerposition jeweils bündig mit der mindestens einen Seitenwand und einer zweiten Seitenwand des Elektronikschranks ab.

Vorzugsweise umfasst die zweite Abdeckungseinheit mindestens zwei trapezförmige zweite Seitenflächen eine rechteckförmige zweite Abdeckfläche, eine rechteckförmige zweite Stirnfläche und eine rechteckförmige Rückseitenfläche. Somit ist auch die zweite Abdeckungseinheit auf einfache Weise durch Metallbleche herstellbar, die bündig miteinander verschweißt sind. Alternativ kann die zweite Abdeckungseinheit selbstverständlich auch aus Kunststoff hergestellt sein. Weiterhin passen die Geometrien der verschieblichen Abdeckungseinheit und der zweiten Abdeckungseinheit so zueinander, dass eine teleskopische Lagerung der verschieblichen Abdeckungseinheit in der Lagerposition gewährleistet ist.

Gemäß einer weiteren vorteilhaften Weiterbildung der vorliegenden Erfindung entspricht eine Länge der Grundseite auf Seiten der Rückseite der zwei trapezförmigen ersten Seitenflächen im Wesentlichen einer Länge der Grundseite auf Seiten der zweiten Stirnfläche der zwei trapezförmigen zweiten Seitenflächen. Somit ist gewährleistet, dass die verschiebliche Abdeckungseinheit im vollständig ausgezogenen Zustand bündig an die zweiten Abdeckungseinheit anschließt und die geschlossene Dachfläche stufenlos und gleichmäßig in Richtung der Rückwand abfallend ausgebildet ist.

Um eine einfach Bedienung der verschieblichen Abdeckungseinheit und hohe Stabilität im vollständig ausgezogenen Zustand zu gewährleisten, kann das Schiebehalterungssystem mindestens eine Teleskopschiene umfassen, die auf der Oberseite der zweiten Abdeckfläche angebracht ist. Alternativ kann das Schiebehalterungssystem mindestens eine Teleskopschiene umfassen, die an mindestens einer der zwei trapezförmigen zweiten Seitenflächen der zweiten Abdeckungseinheit angebracht ist.

Gemäß einer weiteren vorteilhaften Weiterbildung der vorliegenden Erfindung umfasst die verschiebliche Schrankabdeckung mindestens eine drehbare Seitenabdeckung, die in einem aufgefalteten Betriebszustand die Dachfläche vergrößert. Vorzugsweise ist die drehbare Seitenabdeckung dreiecksförmig. Auf diese Weise kann die Dachfläche zusätzlich vergrößert werden, um einen Raum, der entsteht, wenn die Schranktür um mehr als 90° geöffnet ist, abzudecken. Somit kann der vor Niederschlag geschützte Raum vergrößert werden und es entsteht somit auch eine größere Bewegungsfreiheit für die Wartungsarbeiten. Weiterhin kann die drehbare Seitenabdeckung durch die dreiecksförmige Form möglichst material- und platzsparend produziert werden.

Um den Innenraum des Elektronikschrankes und einen Wartungsarbeiter im Wartungsfall vor starker Seitenwinden, seitlichem Niederschlag und Schotterflug, der durch vorbeifahrende Züge verursacht wird, zu schützen, kann der erfindungsgemäße Elektronikschrank weiterhin eine linear verschiebliche Seitenplatte umfassen, die in einem vollständig ausgezogenen Zustand mit der mindestens einen Seitenwand des Elektronikschranks einen geschlossenen Seitenschutz bildet. Vorteilhafterweise umfasst der erfindungsgemäße Elektronikschrank dabei weiterhin mindestens eine zusätzliche Teleskopschiene, die an der mindestens einen Seitenwand befestigt ist, um eine einfache Bedienbarkeit der verschieblichen Seitenplatte und eine hohe Stabilität des geschlossenen Seitenschutzes zu gewährleisten.

Weiterhin kann die zweite Abdeckungseinheit doppelwandig ausgebildet sein, und mindestens ein Lüfter innerhalb der zweiten Abdeckungseinheit angebracht sein, so dass ein Zwischenraum innerhalb der zweiten Abdeckungseinheit und somit das Innengehäuses des Elektronikschrankes zusätzlich gekühlt werden kann. Alternativ oder zusätzlich zu dem mindestens einen Lüfter, können auch mindestens ein anderes aktives Gerät innerhalb der zweiten Abdeckungseinheit angebracht sein.

Die vorliegende Erfindung bezieht sich außerdem auf ein Abdeckungssystem für einen Elektronikschrank, das eine linear verschiebliche Abdeckungseinheit, die aus einer Lagerposition ausziehbar ist umfasst. Weiterhin umfasst das erfindungsgemäße Abdeckungssystem eine zweite Abdeckungseinheit, die so angeordnet ist, dass sie mit der verschieblichen Abdeckungseinheit in einem vollständig ausgezogenen Zustand eine geschlossene Schrankabdeckung bildet, deren Oberseite eine geschlossene Dachfläche bildet, und ein Schiebehalterungssystem, das die verschiebliche Abdeckungseinheit in ausgezogenem Zustand stützt.

Ein solches Abdeckungssystem kann beispielsweise auf Elektronikschränken aller Art montiert werden, um bei diesen ein einteiliges und unflexibles Abdeckungssystem zu ersetzen, so dass der nachgerüstete Elektronikschrank alle Vorteile der vorliegenden Erfindung bietet.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einige Merkmale oder Merkmalskombinationen aus den gezeigten und beschriebenen unterschiedlichen Ausführungsformen für sich eigenständige, erfinderische oder erfindungsgemäße Lösungen darstellen. Es zeigen:
- **Fig. 1**: eine schematische Seitenansicht eines Elektronikschranks gemäß einer ersten vorteilhaften Ausführungsform;
- **Fig. 2**: eine weitere schematische Seitenansicht des Elektronikschranks der Fig. 1;
- **Fig. 3**: eine schematische Frontansicht des Elektronikschranks gemäß der ersten vorteilhaften Ausführungsform;
- **Fig. 4**: eine weitere schematische Frontansicht des Elektronikschranks gemäß der ersten vorteilhaften Ausführungsform;
- **Fig. 5**: eine schematische Draufsicht des Elektronikschranks gemäß einer zweiten vorteilhaften Ausführungsform;
- **Fig. 6**: eine weitere schematische Draufsicht des Elektronikschranks gemäß der zweiten vorteilhaften Ausführungsform;
- **Fig. 7**: eine schematische Frontansicht des Elektronikschranks gemäß der zweiten vorteilhaften Ausführungsform;
- **Fig. 8**: eine weitere schematische Frontansicht des Elektronikschranks gemäß der zweiten vorteilhaften Ausführungsform;
- **Fig. 9**: eine weitere schematische Frontansicht des Elektronikschranks gemäß der zweiten vorteilhaften Ausführungsform;
- **Fig. 10**: eine weitere schematische Frontansicht des Elektronikschranks gemäß der zweiten vorteilhaften Ausführungsform.

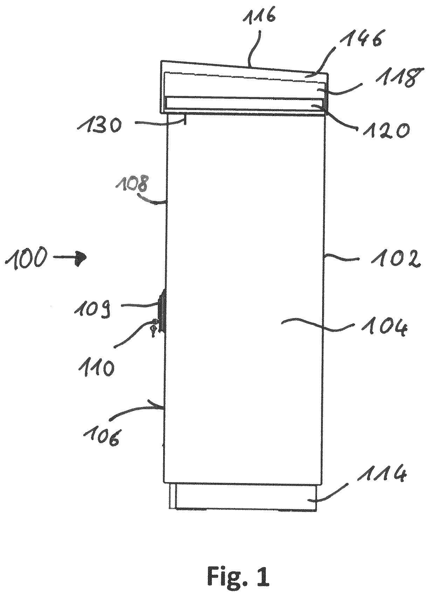

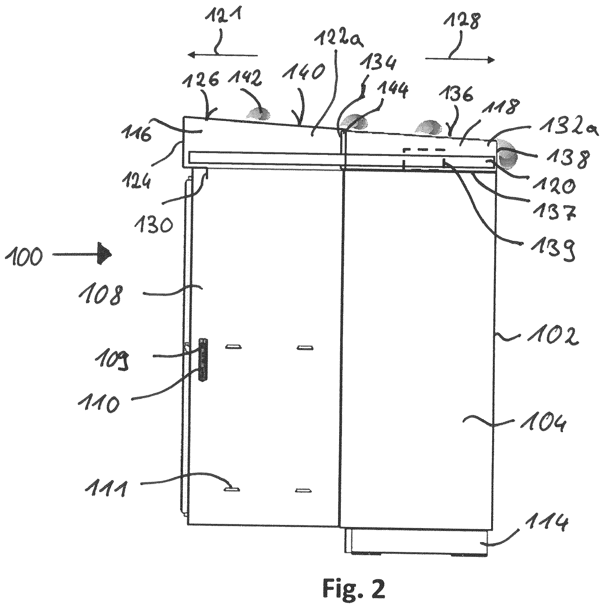

Die vorliegende Erfindung soll nachfolgend mit Bezug auf die Figuren näher erläutert werden. Anhand der Figuren 1 bis 4 wird nun eine erste Ausführungsform gemäß einer vorteilhaften Ausführungsform der vorliegenden Erfindung beschrieben. Die Figuren 1 und 2 zeigen jeweils eine Seitenansicht des Elektronikschrankes 100 gemäß der ersten Ausführungsform. Wie anhand von Figur 1 erkennbar ist, umfasst der Elektronikschrank 100 eine Rückwand 102, mindestens eine Seitenwand 104 und eine Vorderseite 106. Die Rückwand 102 und die Seitenwand 104 können beispielsweise durch doppelwandige abnehmbare Bleche ausgeformt sein, die an einem Aluminiumgestell befestigt sind, um eine stabile Konstruktion des Elektronikschrankes 100 und zusätzliche Kühlung durch die Zwischenbereiche der doppelwandigen Bleche zu gewährleisten. Alternativ können die Rückwand 102 und die Seitenwand 104 auch einwandig ausgeformt sein, um das Gesamtgewicht des Elektronikschrankes 100 und den Materialaufwand in der Herstellung zu verringern.

Um den Innenraum 112 des Elektronikschrankes 100 zugänglich zu machen, umfasst die Vorderseite 106 eine Schranktür 108, die beispielsweise durch gebräuchliche Türangeln drehbar gelagert ist. Weiterhin umfasst die Schranktür 108 einen Türgriff 109, und ein Türschloss 110, durch das die Schranktür 108 absperrbar ist. Wie in Fig. 2 schematisch dargestellt, kann die Schranktür 108 Lüftungsschlitze 111 umfassen, um durch Luftkühlung eine Entwärmung der Elektronikkomponenten im Innenraum 112 des Elektronikschranks 100 zu ermöglichen.

Weiterhin kann der Elektronikschrank 100 optional über einen Sockel 114 verfügen. Dabei dient der Sockel 114 zum einen zur Stabilisation des Elektronikschrankes 100 und bietet zum anderen Stauraum für Kabel mit deren Hilfe die Stromversorgung von in dem Elektronikschrank 100 eingebauten Elektronikkomponenten sichergestellt wird.

Gemäß der vorliegenden Erfindung umfasst der Elektronikschrank 100 weiterhin eine verschiebliche Abdeckungseinheit 116, eine zweite Abdeckungseinheit 118 und ein Schiebehalterungssystem 120.

Figur 1 zeigt die verschiebliche Abdeckungseinheit 116 in einer Lagerposition, während Figur 2 die verschiebliche Abdeckungseinheit 116 in einem vollständig ausgezogenen Zustand zeigt.

Wie insbesondere anhand von Figur 2 erkennbar ist, ist die verschiebliche Abdeckungseinheit 116 in Richtung der Vorderseite 106, d.h. in Richtung des Pfeiles 121 linear verschieblich. Die verschiebliche Abdeckungseinheit 116 umfasst vorzugsweise zwei trapezförmige erste Seitenflächen 122a und 122b, eine rechteckförmige erste Stirnfläche 124 und eine rechteckförmige erste Abdeckfläche 126. Dabei haben die zwei trapezförmigen ersten Seitenflächen 122a und 122b jeweils den Grundriss eines rechtwinkligen Trapezes, wobei die beiden rechten Winkel an den Ecken des unteren Schenkels ausgeformt sind, d.h. des Schenkels der der in der Lagerposition an die mindestens eine Seitenwand 104 oder eine zweite Seitenwand 129 des Elektronikschrankes 100 anschließt.

Der jeweils gegenüberliegende Schenkel der trapezförmigen ersten Seitenflächen 122a und 122b, d.h. derjenige Schenkel, der jeweils die Kante zwischen den ersten Seitenflächen 122a und 122b und der ersten Abdeckfläche 126 bildet, ist in Richtung der Rückwand 102 geneigt. Diese Richtung wird in Figur 2 durch den Pfeil 128 dargestellt. Somit ist insbesondere auch die erste Abdeckfläche 126 in Richtung der Rückwand 102 geneigt. Weiterhin ist die verschiebliche Abdeckungseinheit 116 in Richtung der Rückwand 102 des Elektronikschrankes offen, so dass sie in Richtung der Vorderseite 106 des Elektronikschrankes 100 über die zweite Abdeckungseinheit 118 linear ausziehbar ist.

Die zwei ersten Seitenwände 122a und 122b, die erste Stirnfläche 124 und die erste Abdeckfläche 126 können aus Blechen geformt sein, wie beispielsweise Aluminium-StahlBlechen oder anderen Metallblechen, die miteinander verschweißt werden. Weiterhin können die Außenflächen der Bleche durch eine Anti-Korrosionsschicht, wie beispielsweise eine Aluminium-Zink-Beschichtung oder eine Pulverbeschichtung, geschützt sein, um Feuchtigkeitsschäden an den Blechen zu verhindern. Alternativ können die zwei ersten Seitenwände 122a, 122b, die erste Stirnfläche 124 und die erste Abdeckfläche 126 auch aus Kunststoff geformt sein.

Wie in den Figuren 1 und 2 gezeigt, umfasst die verschiebliche Abdeckungseinheit 116 weiterhin einen Vorsprung 130, der als Griff dient, mit dessen Hilfe die verschiebliche Abdeckungseinheit 116 auf einfache Art und Weise linear herausgezogen werden kann. Der Vorsprung 130 ist vorzugsweise unterhalb der verschieblichen Abdeckungseinheit 116 angebracht, wobei er von der ersten Stirnfläche 124 leicht in Richtung der Rückseite des Elektronikschrankes 100 versetzt ist. Somit befindet sich der Vorsprung 130 innerhalb des Innenraums 112 des Elektronikschrankes 100, wenn sich die verschiebliche Abdeckungseinheit 116 in der Lagerposition befindet und die Schranktür 108 geschlossen ist.

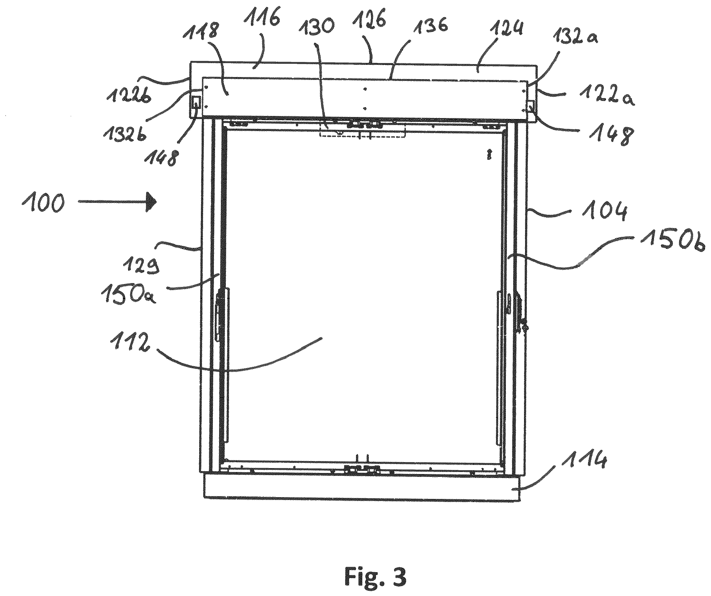

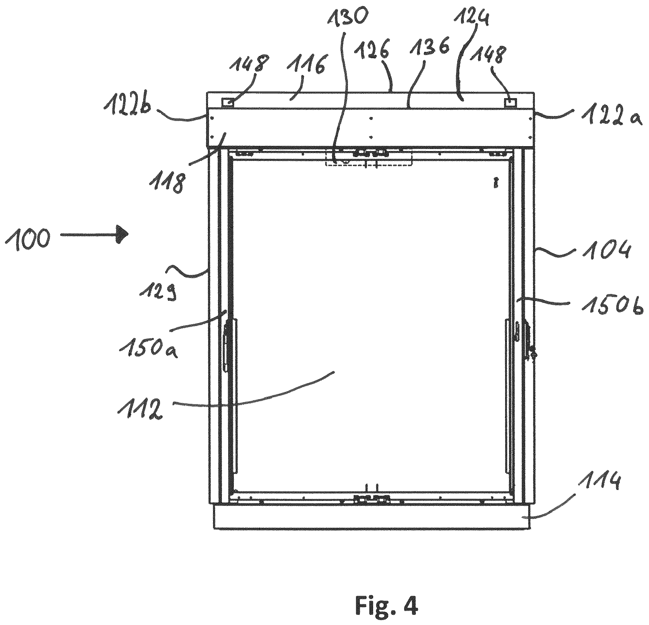

In den Figuren 3 und 4 ist der Vorsprung 130 schematisch strichliert dargestellt, um anzudeuten, dass der Vorsprung 130 in den Innenraum 112 des Elektronikschrankes 100 hineinragt, wenn sich die verschiebliche Abdeckungseinheit 116 in der Lagerposition befindet. Vorteilhafterweise blockiert der Vorsprung 130 so die verschiebliche Abdeckungseinheit 116, wenn diese sich in der Lagerposition befindet und die Schranktür 108 geschlossen ist, so dass die verschiebliche Abdeckungseinheit 116 vor unbefugtem Zugriff geschützt ist.

Wie in den Figuren 1-4 schematisch dargestellt, umfasst die zweite Abdeckungseinheit 118 vorzugsweise zwei trapezförmige zweite Seitenflächen 132a und 132b, eine rechteckförmige erste Stirnfläche 134 und eine rechteckförmige erste Abdeckfläche 136. Weiterhin umfasst die zweite Abdeckungseinheit 118 vorzugsweise eine Rückseitenfläche 138. Dabei haben die zwei trapezförmigen zweiten Seitenflächen 132a und 132b jeweils den Grundriss eines rechtwinkligen Trapezes, wobei die beiden rechten Winkel an den Ecken des unteren Schenkels ausgeformt sind, d.h. des Schenkels der an die mindestens eine Seitenwand 104 oder eine zweite Seitenwand 129 des Elektronikschrankes 100 anschließt.

Der jeweils gegenüberliegende Schenkel der trapezförmigen zweiten Seitenflächen 132a und 132b, d.h. derjenige Schenkel, der jeweils die Kante zwischen den zweiten Seitenflächen 132a, 132b und der zweiten Abdeckfläche 136 bildet, ist in Richtung der Rückwand 102 geneigt. Diese Richtung wird in Figur 2 durch den Pfeil 128 dargestellt. Somit ist insbesondere auch die zweite Abdeckfläche 136 in Richtung der Rückwand 102 geneigt.

Die zwei zweiten Seitenwände 132a und 132b, die zweite Stirnfläche 134, die zweite Abdeckfläche 136 und die Rückseitenfläche 138 können aus Blechen wie beispielsweise Aluminium-Stahl Blechen oder anderen Metallblechen hergestellt sein, die miteinander verschweißt werden. Weiterhin können die Außenflächen der Bleche durch eine Anti-Korrosionsschicht, wie beispielsweise eine Aluminium-Zink-Beschichtung oder eine Pulverbeschichtung, geschützt sein, um Feuchtigkeitsschäden an den Blechen zu verhindern. Alternativ können die zwei zweiten Seitenwände 132a und 132b, die zweite Stirnfläche 134, die zweite Abdeckfläche 136 und die Rückseitenfläche 138 auch aus Kunststoff geformt sein.

Weiterhin kann die zweite Abdeckungseinheit 118 doppelwandig ausgeformt sein und zusätzlich eine Innenabdeckung 137 umfassen, die den Innenraum 112 des Elektronikschrankes 100 von einem Zwischenraum in der zweiten Abdeckungseinheit 118, der zwischen der Innenabdeckung 137 und der zweiten Abdeckungsfläche 136 ausgeformt ist, abtrennt. Um zusätzliche Kühlung für den Innenraum 112 bereitzustellen, kann ein Lüfter 139 in den Zwischenraum angebracht sein, der durch einen Luftstrom den Innenraum 112 kühlt. Der Lüfter 139, in Figur 2 schematisch durch eine strichlierte Box dargestellt, befindet sich auch in dem vollständig ausgezogenen Zustand der verschieblichen Abdeckungseinheit 116 immer unterhalb der zweiten Abdeckungsfläche 136 und ist so auch in diesem Zustand vor Niederschlag, Staub und starken Winden geschützt.

Insbesondere zeigt Figur 2, dass die zweite Abdeckungseinheit 118 so angeordnet ist, dass sie mit der verschieblichen Abdeckungseinheit 116 in vollständig ausgezogenem Zustand eine Schrankabdeckung bildet, deren Oberseite eine geschlossene Dachfläche 140 aufweist. Die geschlossene Dachfläche 140 wird dabei von der ersten Abdeckfläche 126, der verschieblichen Abdeckungseinheit 116 und der zweiten Abdeckfläche 136 der zweiten Abdeckungseinheit 118 gebildet, so dass die geschlossene Dachfläche 140 in Richtung der Rückwand 102 des Elektronikschrankes 100 geneigt ist. Somit wird Niederschlagswasser, dass in Figur 2 schematisch anhand der Wassertropfen 142 dargestellt ist, in Richtung der Rückseite und somit weg von den Öffnungen des Elektronikschrankes 100 geleitet.

An dieser Stelle soll angemerkt werden, dass die Neigung der geschlossenen Dachfläche 140 auch in einem Übergangsbereich 144 von der verschieblichen Abdeckungseinheit 116 zur zweiten Abdeckungseinheit 118 im wesentlichen konstant ist. Dies wird dadurch erreicht, dass eine Länge der Grundseite der zwei trapezförmigen ersten Seitenflächen 122a, 122b auf Seiten der Rückwand 102 des Elektronikschranks 100 im Wesentlichen einer Länge der Grundseite der zwei trapezförmigen zweiten Seitenflächen 132a, 132b auf Seiten der Vorderseite 106 des Elektronikschrankes entspricht.

Somit ist es möglich, dass die verschiebliche Abdeckungseinheit 116 in der Lagerposition teleskopisch über der zweiten Abdeckungseinheit 118 gelagert ist, wie in Figur 1 schematisch dargestellt. Durch die beschriebenen Geometrien der verschieblichen Abdeckungseinheit 116 und der zweiten Abdeckungseinheit 118 bildet sich in der Lagerposition ein Luftspalt 146 zwischen der Oberseite der zweiten Abdeckfläche 136 und der Unterseite der ersten Abdeckfläche 126 aus, so dass Feuchtigkeit, die sich im Betriebszustand auf der Oberseite der zweiten Abdeckfläche 136 gebildet hat, auch in der Lagerposition weiter ablaufen oder verdunsten kann.

Wie anhand der Figur 2 gezeigt ist, stützt das Schiebehalterungssystem 120 die verschiebliche Abdeckungseinheit 116 in vollständig ausgefahrenem Zustand.

Dabei kann das Schiebehalterungssystem 120 durch mindestens eine Teleskopschiene 148 ausgeformt sein, die an einer der zweiten Seitenflächen 132a, 132b der zweiten Abdeckungseinheit 118 befestigt ist. Wie in Figur 3 gezeigt, ist es vorteilhaft, wenn das Schiebehalterungssystem 120 durch zwei Teleskopschienen 148 ausgeformt ist, die jeweils an einer der zweiten Seitenflächen 132a, 132b der zweiten Abdeckungseinheit 118 befestigt sind. So kann die Traglast, die durch die verschiebliche Abdeckungseinheit 116 auf die Teleskopschiene 148 wirkt, besser verteilt werden und es kann eine hohe Stabilität der verschieblichen Abdeckungseinheit 116 im vollständig ausgefahrenen Zustand gewährleistet werden. In jedem Falle ist das Schiebehalterungssystem 120 auf solche Art an dem Elektronikschrank 100 angebracht, dass die Schranktür 108 frei beweglich ist, wenn sich die verschiebliche Abdeckungseinheit 116 in dem vollständig ausgezogenen Zustand befindet.

Alternativ kann das Schiebehalterungssystem 120 auch durch mindestens eine, vorzugsweise aber zwei Teleskopschienen 148 ausgeformt sein kann, die auf der zweiten Abdeckfläche 136 der zweiten Abdeckungseinheit 118 befestigt sind, wie es in Figur 4 gezeigt ist. Durch diese Anordnung kann eine hohe Stabilität der verschieblichen Abdeckfläche 116 im vollständig ausgefahrenen Zustand gewährleistet werden, während Platz an den Seiten des Elektronikschrankes 200 eingespart werden kann. Weiterhin ist es dadurch möglich, die verschiebliche Abdeckungseinheit 116 schmaler und materialsparend zu konstruieren.

Zudem ist es vorteilhaft, wenn die mindestens eine Teleskopschiene 148 eine Auszuglänge hat, die im Wesentlichen einer Länge der zwei trapezförmigen ersten Seitenflächen 122a und 122b zwischen den beiden parallelen Grundseiten entspricht, so dass die verschiebliche Abdeckungseinheit 116 möglichst vollständig aus der Lagerposition herausziehbar ist, wie in Fig. 2 gezeigt. So kann eine optimale Vergrößerung der geschlossenen Dachfläche 140 im vollständig ausgezogenem Zustand erreicht werden.

Weiterhin kann die mindestens eine Teleskopschiene 148 über eine Arretier-Vorrichtung verfügen, mit deren Hilfe eine Position der verschieblichen Abdeckungseinheit fixiert werden kann. Vorzugsweise ist die Arretierung-Vorrichtung dabei in solcher Weise angebracht, dass sie nur zugänglich ist, wenn die Schranktür 108 geöffnet ist. Beispielsweise kann die Arretier-Vorrichtung eine Arretierung sein, die das Schiebehalterungssystem 120 mindestens in der Lagerposition und in dem vollständig ausgezogenen Zustand arretiert. Als Arretierung kann dabei beispielsweise eine mechanische Verriegelung, die in eine der mindestens einen Teleskopschiene 148 integriert ist, vorgesehen sein. Alternativ kann auch mindestens ein Stoppgummi vorgesehen sein, der an einer der mindestens einen Teleskopschiene angebracht ist.

Wie in Fig. 4 gezeigt, ist es vorteilhaft, wenn die verschiebliche Abdeckungseinheit 116 so angeordnet ist, dass die zwei ersten Seitenwände 122a und 122b in der Lagerposition jeweils bündig mit der mindestens einen Seitenwand 104 und einer zweiten Seitenwand 129 des Elektronikschranks 100 abschließen. Somit kann eine material- und platzsparende Bauweise des Elektronikschrankes 100 erreicht werden und die Angriffsfläche für Vandalismus kann verringert werden.

Wie in den Figuren 3 und 4 gezeigt ist, kann die Schranktür 108 des Elektronikschranks 100 durch eine Doppeltür ausgeformt sein, die zwei Türflügel 150a und 150b umfasst. Somit kann durch Öffnen der Schranktür 108 und Herausziehen der verschieblichen Abdeckungseinheit 116 ein geschützter Raum auf der Vorderseite 106 des Elektronikschrankes 100 gebildet werden, der durch die beiden Türflügel 150a und 150b der Schranktür 108 und die geschlossene Dachfläche 140 begrenzt ist und nur nach vorne in Richtung des Pfeiles 121 offen ist.

Dieser Raum ist durch die geschlossene Dachfläche 140 vor vertikalem Niederschlag und durch die Türflügel 150a und 150b der Schranktür 108 vor seitlichem Niederschlag, starken Seitenwinden und Schotterflug geschützt. Insbesondere wird der geschützte Raum auch vor starken Windstößen, Staubaufwirbelungen und Schotterflug, die von vorbeifahrenden Zügen verursacht werden, geschützt. Weiterhin bietet der geschützte Raum auch einen Blendschutz und Schutz vor stark einfallender Sonnenstrahlung. Der geschützte Raum bietet somit einen komfortablen Platz für einen Wartungsarbeiter, um Wartungsarbeiten oder Modifikationen an den Elektronikkomponenten im Innenraum 112 des Elektronikschrankes 100 durchzuführen.

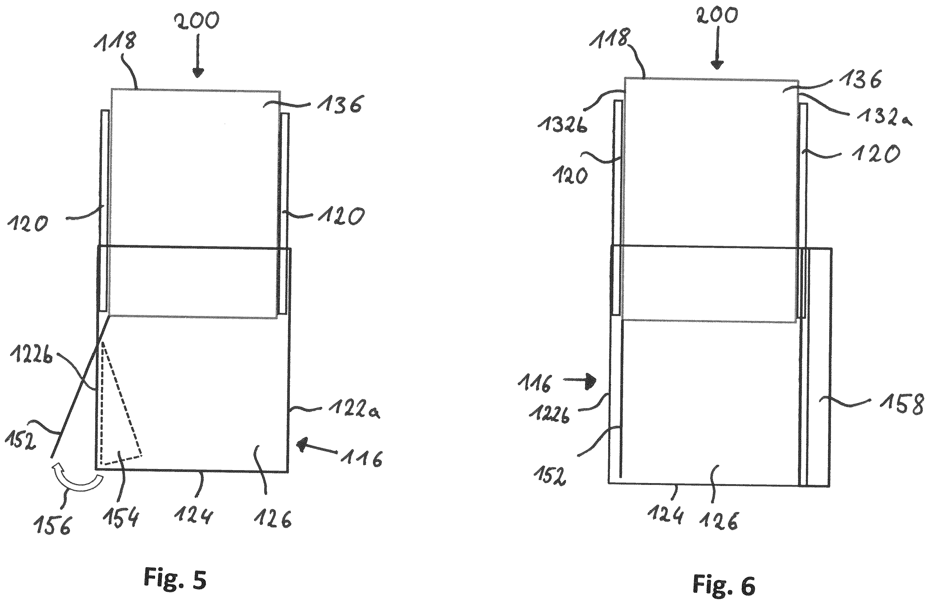

Die Figuren 5 bis 10 zeigen eine zweite Ausführungsform des erfindungsgemäßen Elektronikschrankes 200. Selbstverständlich gelten alle Aspekte und Vorteile, die für die erste Ausführungsform beschrieben wurden, auch für die zweite Ausführungsform. Die zweite Ausführungsform unterscheidet sich von der ersten Ausführungsform lediglich dadurch, dass die Schranktür 108 durch eine Einzeltür mit einem Türflügel 152 an Stelle einer Doppeltür ausgeformt ist.

Wie in Figur 5 anhand der strichlierten Linien schematisch dargestellt, kann die verschiebliche Abdeckungseinheit 116 optional eine drehbare Seitenabdeckung 154 umfassen, mit deren Hilfe in einem Betriebszustand die Fläche der geschlossenen Dachfläche 140 in seitlicher Richtung vergrößert werden kann. Dabei ist die drehbare Seitenabdeckung 154 in Richtung des Pfeils 156 drehbar. Dadurch kann ein Raum abgedeckt werden, der entsteht, wenn der Türflügel 152 um mehr als 90° geöffnet ist. Da dieser Raum auf Grund der Drehbewegung des Türflügels 152 immer einen dreiecksförmigen Grundriss besitzt, ist die drehbare Seitenabdeckung 154 vorzugsweise ebenfalls dreiecksförmig, um möglichst materialsparend herstellbar und platzsparend verstaubar zu sein.

Die drehbare Seitenabdeckung 154 kann beispielsweise durch einen Bolzen an der Unterseite der verschieblichen Abdeckungseinheit 116 drehbar befestigt sein. Weiterhin kann die drehbare Seitenabdeckung aus einem Metallblech, das mit einer Aluminium-Zink-Beschichtung oder einer Pulverbeschichtung beschichtet ist, hergestellt sein. Alternativ kann die drehbare Seitenabdeckung auch aus einem Kunststoff geformt sein. Selbstverständlich kann die verschiebliche Abdeckungseinheit 116 auch eine zweite drehbare Seitenabdeckung umfassen, so dass auf Seiten jeder der beiden ersten Seitenflächen 122a und 122b jeweils eine drehbare Seitenabdeckung vorgesehen sein kann. Dies ist insbesondere auch vorteilhaft im Falle der ersten Ausführungsform der vorliegenden Erfindung, wo die Schranktür 108 als Doppeltür ausgeformt ist.

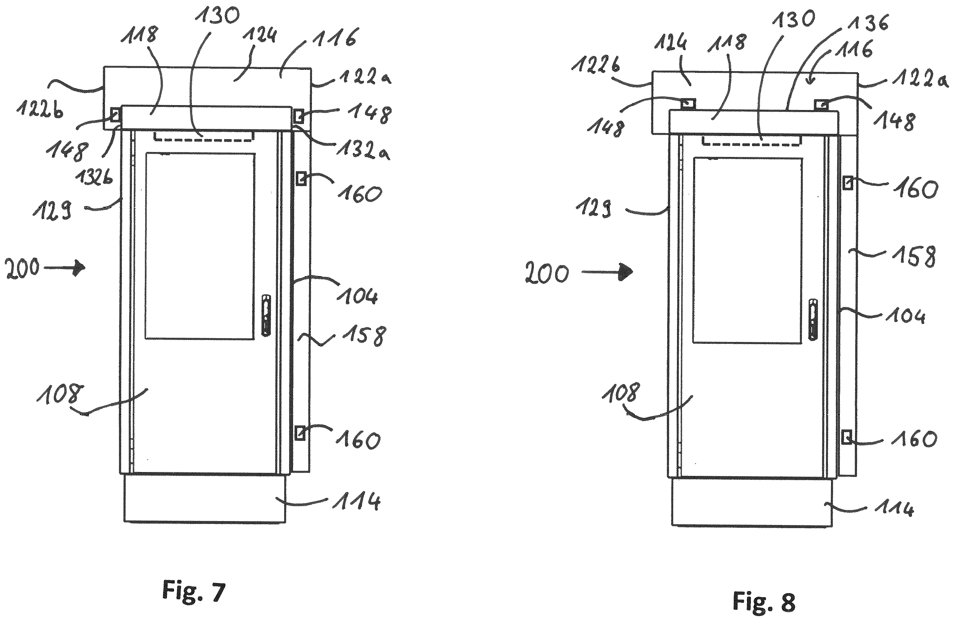

Weiterhin zeigen die Figuren 6 bis 9, dass der Elektronikschrank 200 optional eine verschiebliche Seitenplatte 158 umfassen kann, die linear in Richtung der Vorderseite 106 des Elektronikschrankes 200 ausziehbar ist. In diesem Fall kann eine zusätzliche Teleskopschiene 160 vorgesehen sein, die an der mindestens einen Seitenwand 104 des Elektronikschrankes 200 angebracht ist. Mit Hilfe der zusätzlichen Teleskopschiene 160 ist die verschiebliche Seitenplatte 158 beweglich gelagert und wird in einem vollständig ausgezogenen Zustand gestützt. Um die Stabilität der verschieblichen Seitenplatte 158 in ausgezogenem Zustand zu erhöhen, ist es vorteilhaft, wenn der Elektronikschrank 200 zwei zusätzliche Teleskopschienen 160 umfasst, die an der mindestens einen Seitenwand 104 angebracht sind, wie in den Figuren 7 bis 9 gezeigt.

Die verschiebliche Seitenplatte 158 kann beispielsweise aus einem Metallblech, das mit einer Aluminium-Zink-Beschichtung oder einer Pulverbeschichtung beschichtet ist, hergestellt sein. Alternativ kann die verschiebliche Seitenplatte 158 aber beispielsweise auch aus Kunststoff hergestellt sein.

Wie insbesondere in Figur 6 schematisch dargestellt ist, bildet die verschiebliche Seitenplatte 158 in einem vollständig ausgezogenen Zustand mit der mindestens einen Seitenwand 104 des Elektronikschrankes 200 einen geschlossenen Seitenschutz. Somit kann durch Öffnen der Schranktür 108 und Herausziehen der verschieblichen Abdeckungseinheit 116 und der verschieblichen Seitenplatte 158 auf Seiten der Vorderseite 106 vor dem Elektronikschrankes 200 ein geschützter Raum geformt werden, der durch den Türflügel 152 der Schranktür 108, die verschiebliche Abdeckungseinheit 116 und die verschiebliche Seitenplatte 158 begrenzt ist. Dabei bietet die verschiebliche Abdeckungseinheit 116 Schutz vor horizontalem Niederschlag. Weiterhin bieten insbesondere der Türflügel 152 und die verschiebliche Seitenplatte 158 Schutz vor seitlichem Niederschlag, sowie starken Seitenwinden und Schotterflug, die von vorbeifahrenden Zügen verursacht werden.

Fig. 7 zeigt, dass auch in der zweiten Ausführungsform des erfindungsgemäßen Elektronikschrankes 200, das Schiebehalterungssystem 120 durch zwei Teleskopschienen 148 ausgeformt sein kann, die jeweils an einer der zweiten Seitenflächen 132a, 132b der zweiten Abdeckungseinheit 118 befestigt sind.

Alternativ zeigt Fig. 8 ein Beispiel des erfindungsgemäßen Elektronikschrankes 200, bei dem das Schiebehalterungssystem 120 durch mindestens eine, vorzugsweise aber zwei Teleskopschienen 148 ausgeformt ist, die auf der zweiten Abdeckfläche 136 der zweiten Abdeckungseinheit 118 befestigt sind. Durch diese Anordnung kann eine hohe Stabilität der verschieblichen Abdeckfläche im vollständig ausgefahrenen Zustand gewährleistet werden, während Platz an den Seiten des Elektronikschrankes 200 eingespart werden kann. Zudem ist es möglich, die verschiebliche Abdeckungseinheit 116 schmal und materialsparend zu konstruieren.

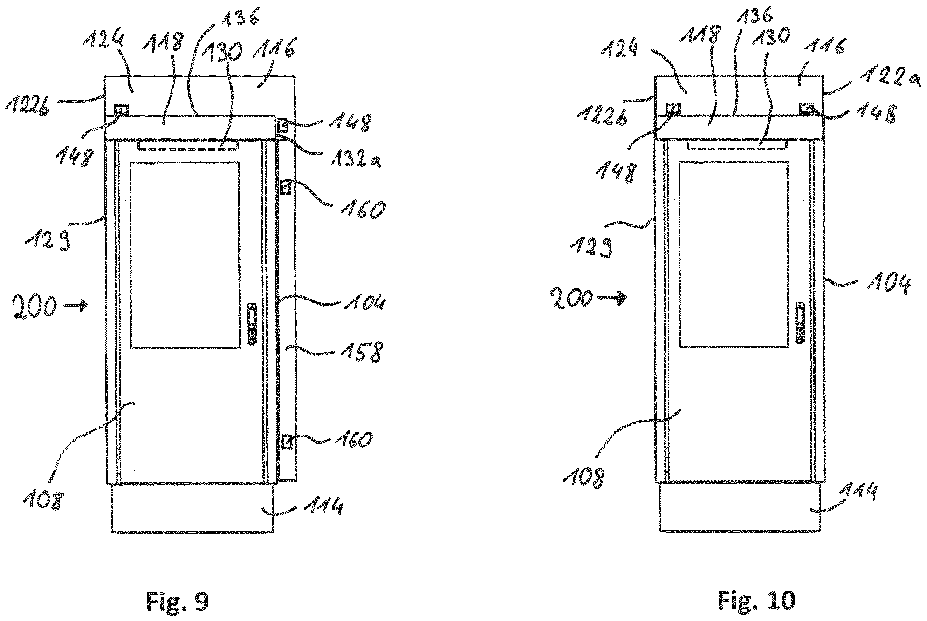

Weiterhin zeigt Fig. 9, dass das Schiebehalterungssystem 120 auch durch eine Teleskopschiene 148, die an der zweiten Seitenfläche 132a der zweiten Abdeckungseinheit 118 auf Seiten der verschieblichen Seitenplatte 158 befestigt ist, sowie durch mindestens eine weitere Teleskopschiene 148, die auf der zweiten Abdeckfläche 136 der zweiten Abdeckungseinheit 118 befestigt ist, ausgeformt sein kann. Auf diese Weise kann die verschiebliche Abdeckungseinheit 116 so angeordnet werden, dass die erste Seitenwand 122b in der Lagerposition bündig mit der zweiten Seitenwand 129 des Elektronikschranks 200 abschließt.

Die Figur 10 zeigt ein weiteres Beispiel des erfindungsgemäßen Elektronikschrankes 200 gemäß der zweiten Ausführungsform. Hierbei ist das Schiebehalterungssystem 120 durch mindestens eine, vorzugsweise aber zwei Teleskopschienen 148 ausgeformt, die auf der zweiten Abdeckfläche 136 der zweiten Abdeckungseinheit 118 befestigt sind. Dadurch ist es möglich, die verschiebliche Abdeckungseinheit 116 so anzuordnen, dass die zwei ersten Seitenwände 122a und 122b in der Lagerposition jeweils bündig mit der mindestens einen Seitenwand 104 und der zweiten Seitenwand 129 des Elektronikschranks 200 abschließen. Somit kann eine material- und platzsparende Bauweise des Elektronikschrankes 200 erreicht werden und die Angriffsfläche für Vandalismus kann verringert werden.

In den Figuren 7 bis 10 ist der Vorsprung 130 der verschieblichen Abdeckungseinheit 116 jeweils wieder strichliert dargestellt, um zu verdeutlichen, dass sich der Vorsprung 130 bei geschlossener Schranktür 108 im Innenraum 112 des Elektronikschrankes 200 befindet und auf diese Weise ein Herausziehen der verschieblichen Abdeckungseinheit 116 durch die Schranktür 108 blockiert wird.

Auch wenn ein Abdeckungssystem, das eine verschiebliche Abdeckungseinheit 116, eine zweite Abdeckungseinheit 118 und ein Schiebehalterungssystem 120 umfasst, bisher nur in Einheit mit einem Elektronikschrank beschrieben wurde, bezieht sich die vorliegende Erfindung auch auf das Abdeckungssystem als solches. Ein solches Abdeckungssystem kann beispielsweise verwendet werden, um einen Elektronikschrank, der über eine einteilige Abdeckungseinheit verfügt, mit dem Abdeckungssystem gemäß der vorliegenden Erfindung nachzurüsten.

Optional kann beispielsweise ein separates Schloss an dem erfindungsgemäßen Abdeckungssystem vorgesehen sein, so dass das Abdeckungssystem unabhängig von der Schranktür des Elektronikschrankes absperrbar ist.

### Bezugszeichenliste

| | |
|---|---|
| 100 | Elektronikschrank |
| 102 | Rückwand |
| 104 | Seitenwand |
| 106 | Vorderseite |
| 108 | Schranktür |
| 109 | Türgriff |
| 110 | Türschloss |
| 111 | Lüftungsschlitze |
| 112 | Innenraum |
| 114 | Sockel |
| 116 | verschiebliche Abdeckunqseinheit |
| 118 | zweite Abdeckunqseinheit |
| 120 | Schiebehalterungssystem |
| 121, 128, 156 | Richtungspfeile |
| 122a, 122b | erste Seitenflächen |
| 124 | erste Stirnfläche |
| 126 | erste Abdeckfläche |
| 129 | zweite Seitenwand |
| 130 | Vorsprung |
| 132a, 132b | zweite Seitenflächen |
| 134 | zweite Stirnfläche |
| 136 | zweite Abdeckfläche |
| 137 | Innenabdeckung |
| 138 | Rückseitenfläche |
| 139 | Lüfter |
| 140 | qeschlossene Dachfläche |
| 142 | Wassertropfen |
| 144 | Überqanqsbereich |
| 146 | Luftspalt |
| 148 | Teleskopschienen |
| 150a, 150b | Türflügel |
| 152 | Türflügel |
| 154 | drehbare Seitenabdeckung |
| 158 | verschiebliche Seitenplatte |
| 160 | zusätzliche Teleskopschiene |

## Patentansprüche

1. Elektronikschrank (100) mit einem Innenraum (112) zur Aufnahme von Elektronikkomponenten, wobei der Elektronikschrank (100) umfasst:
mindestens eine Seitenwand (104), eine Rückwand (102) und eine Schranktür (108);
eine linear verschiebliche Abdeckungseinheit (116), die aus einer Lagerposition in Richtung der Schranktür (108) ausziehbar ist;
weiterhin umfassend eine zweite Abdeckungseinheit (118), die so angeordnet ist, dass sie mit der verschieblichen Abdeckungseinheit (116) in einem vollständig ausgezogenen Zustand eine geschlossene Schrankabdeckung bildet, deren Oberseite eine geschlossene Dachfläche (140) bildet; und
ein Schiebehalterungssystem (120), das die verschiebliche Abdeckungseinheit (116) in ausgezogenem Zustand stützt.

2. Elektronikschrank (100) nach Anspruch 1, wobei die geschlossene Dachfläche (140) in Richtung der Rückwand (102) geneigt ist.

3. Elektronikschrank (100) nach Anspruch 2, wobei die verschiebliche Abdeckungseinheit (116) in der Lagerposition teleskopisch über der zweiten Abdeckungseinheit (118) gelagert ist.

4. Elektronikschrank (100) nach einem der Ansprüche 1 bis 3, wobei das Schiebehalterungssystem (120) eine Arretier-Vorrichtung umfasst, mit deren Hilfe die Position der verschieblichen Abdeckungseinheit (116) fixiert werden kann.

5. Elektronikschrank (100) nach Anspruch 4, wobei die Arretier-Vorrichtung nur zugänglich ist, wenn die Schranktür (108) des Elektronikschrankes (100) geöffnet ist.

6. Elektronikschrank (100) nach einem der Ansprüche 1 bis 5, wobei die verschiebliche Abdeckungseinheit (116) mindestens zwei trapezförmige erste Seitenflächen (122a, 122b), eine rechteckförmige erste Stirnfläche (124) und eine rechteckförmige erste Abdeckfläche (126) umfasst.

7. Elektronikschrank (100) nach Anspruch 6, wobei die zwei trapezförmigen ersten Seitenflächen (122a, 122b) jeweils durch ein rechtwinkliges Trapez ausgeformt sind, das an einem der beiden Schenkel jeweils zwei rechte Winkel umfasst.

8. Elektronikschrank (100) nach einem der Ansprüche 6 oder 7, wobei die zwei ersten trapezförmigen Seitenflächen (122a, 122b) in der Lagerposition jeweils bündig mit der mindestens einen Seitenwand (104) und einer zweiten Seitenwand (129) des Elektronikschranks abschließen.

9. Elektronikschrank (100) nach einem der Ansprüche 1 bis 8, wobei die zweite Abdeckungseinheit (118) mindestens zwei trapezförmige zweite Seitenflächen (132a, 132b), eine rechteckförmige zweite Abdeckfläche (136), eine rechteckförmige zweite Stirnfläche (134) und eine rechteckförmige Rückseitenfläche (138) umfassen.

10. Elektronikschrank (100) nach Anspruch 9, wobei eine Länge der Grundseite auf Seiten der Rückseite der zwei trapezförmigen ersten Seitenflächen (122a, 122b) im Wesentlichen einer Länge der Grundseite auf Seiten der zweiten Stirnfläche (134) der zwei trapezförmigen zweiten Seitenflächen (132a, 132b) entspricht.

11. Elektronikschrank (100) nach einem der Ansprüche 9 oder 10, wobei das Schiebehalterungssystem (120) mindestens eine Teleskopschiene (148) umfasst, die auf der Oberseite der zweiten Abdeckfläche (136) angebracht ist, und/oder wobei das Schiebehalterungssystem (120) mindestens eine Teleskopschiene (148) umfasst, die an mindestens einer der zwei trapezförmigen zweiten Seitenflächen (132a, 132b) der zweiten Abdeckungseinheit (118) angebracht ist.

12. Elektronikschrank (100) nach einem der Ansprüche 1 bis 11, wobei die verschiebliche Abdeckungseinheit (116) mindestens eine drehbare Seitenabdeckung (154) umfasst, die in einem aufgefalteten Betriebszustand die Dachfläche vergrößert und/oder wobei die drehbare Seitenabdeckung (154) dreiecksförmig ist.

13. Elektronikschrank (100) nach einem der Ansprüche 1 bis 12, weiterhin umfassend eine linear verschiebliche Seitenplatte (158), die in einem vollständig ausgezogenen Zustand mit der mindestens einen Seitenwand (104) des Elektronikschranks (100) einen geschlossenen Seitenschutz bildet und/oder weiterhin umfassend mindestens eine zusätzliche Teleskopschiene (160), die an der mindestens einen Seitenwand (104) befestigt ist.

14. Elektronikschrank (100) nach einem der Ansprüche 1 bis 13, wobei die zweite Abdeckungseinheit (118) doppelwandig ausgebildet ist, und mindestens ein Lüfter (139) innerhalb der zweiten Abdeckungseinheit (118) angebracht ist.

15. Abdeckungssystem für einen Elektronikschrank (100), wobei das Abdeckungssystem umfasst:
eine linear verschiebliche Abdeckungseinheit (116), die aus einer Lagerposition ausziehbar ist;
weiterhin umfassend eine zweite Abdeckungseinheit (118), die so angeordnet ist,
dass sie mit der verschieblichen Abdeckungseinheit (116) in einem vollständig ausgezogenen Zustand eine geschlossene Schrankabdeckung bildet, deren Oberseite eine geschlossene Dachfläche (140) bildet; und
ein Schiebehalterungssystem (120), das die verschiebliche Abdeckungseinheit (116) in ausgezogenem Zustand stützt.
